**Europäisches Patentamt**

**European Patent Office**

**Office européen des brevets**

(19)

(11) Veröffentlichungsnummer : **0 130 442**
**B1**

(12)

# EUROPÄISCHE PATENTSCHRIFT

(45) Veröffentlichungstag der Patentschrift :
11.11.87

(21) Anmeldenummer : 84106870.3

(22) Anmeldetag : 15.06.84

(51) Int. Cl.⁴ : **H 01 L 39/02**, H 01 R 4/68,
B 23 K 20/10, H 01 F 7/22

(54) **Extrem widerstandsarme Verbindungseinrichtung zwischen den Endstücken zweier Supraleiter.**

(30) Priorität : 30.06.83 DE 3323576

(43) Veröffentlichungstag der Anmeldung :
09.01.85 Patentblatt 85/02

(45) Bekanntmachung des Hinweises auf die Patenterteilung : 11.11.87 Patentblatt 87/46

(84) Benannte Vertragsstaaten :
DE FR GB NL

(56) Entgegenhaltungen :
CH-A- 482 317
DE-A- 1 665 790
GB-A- 1 073 207
GB-A- 1 170 200
US-A- 3 422 529
PATENTS ABSTRACTS OF JAPAN, Band 4, Nr. 59 (E-9)[541], 2. Mai 1980, Seite 65 E 9; & JP - A - 55 29 135 (MITSUBISHI DENKI K.K.) 01.03.1980
WELDING JOURNAL, Band 42, Nr. 9, September 1963, Seiten 411-415, Miami, US; K.M. RALLS et al.: "Joining current contacts to superconducting wire"

(73) Patentinhaber : **Siemens Aktiengesellschaft Berlin und München**
**Wittelsbacherplatz 2**
**D-8000 München 2 (DE)**

(72) Erfinder : **Neumüller, Heinz-Werner, Dr.**
**Karl-Bröger-Strasse 18**
**D-8521 Uttenreuth (DE)**
Erfinder : **Pohl, Gerhard**
**Hauptstrasse 36**
**D-8551 Heiligenstadt (DE)**
Erfinder : **Moll, Helmut**
**Haselhofstrasse 32**
**D-8520 Erlangen (DE)**

EP 0 130 442 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung bezieht sich auf eine Verbindungseinrichtung zwischen den Endstücken zweier auf kryogene Betriebstemperatur abzukühlender Supraleiter, die jeweils in eine Matrix aus normalleitendem Stabilisierungsmaterial eingebettete supraleitende Leiteradern enthalten, wobei die Enden dieser supraleitenden Leiteradern von dem Stabilisierungsmaterial entkleidet, unmittelbar aneinandergefügt und miteinander verschweißt sind, und wobei zwischen dem Stabilisierungsmaterial der Supraleiter eine elektrisch gut leitende Brücke aus normalleitendem Material ausgebildet ist.

Eine derartige Verbindungseinrichtung ist aus der DE-A-1 939 224 bekannt.

Für supraleitende Magnetspulenwicklungen kann insbesondere ein sogenannter Kurzschlußbetrieb vorgesehen werden. Ist nämlich das magnetische Feld der Magnetwicklung einmal aufgebaut, so können zur Speicherung der in die Wicklung eingespeisten elektrischen Energie die Enden der Wicklung mittels eines extrem widerstandsarmen Dauerstromschalters kurzgeschlossen werden. Der Strom fließt dann in dem so ausgebildeten kurzgeschlossenen Stromkreis, und die zur Erregung der Magnetwicklung erforderliche Stromversorgung kann somit unterbrochen werden. Die Dämpfung des Stromes, d. h. sein Abklingverhalten, hängt dabei im wesentlichen von den Übergangswiderständen zwischen den einzelnen supraleitenden Teilen dieses Stromkreises ab. Derartige Übergangswiderstände treten nicht nur an dem Dauerstromschalter auf, sondern ergeben sich auch an Verbindungen der Endstücke einzelner Supraleiterteile, aus denen die Magnetwicklung im allgemeinen zusammengesetzt wird.

Für die Feldmagnete von Kernresonanz-Apparaturen wird im allgemeinen eine hohe zeitliche Feldkonstanz gefordert. Es bieten sich deshalb hochauflösende Systeme mit supraleitenden Feldspulen an, die im Kurzschlußbetrieb arbeiten. Entsprechende Systeme der Kernspin-Tomographie müssen beispielsweise eine zeitliche Feldkonstanz von $\Delta B/B < 10^{-7}$ aufweisen. Der im Stromkreis der Magnetwicklung liegende Gesamtwiderstand, der sich aus den Widerstandsbeiträgen der Leiterverbindungen innerhalb der Wicklung und dem Übergangswiderstand des Dauerstromschalters zusammensetzt, muß deshalb beispielsweise bei einer Induktivität von 74 H kleiner als $2 \times 10^{-9} \ \Omega$ sein. Da sich die einzelnen Magnetwicklungen eines solchen Systems beispielsweise aus 17 einzelnen Leiterstücken zusammensetzen, wird für eine einzelne Verbindung zwischen den Endstücken zweier Supraleiter ein Übergangswiderstand von etwa $10^{-11} \ \Omega$ angestrebt.

Verbindungseinrichtungen mit derart kleinen Übergangswiderständen lassen sich im allgemeinen durch supraleitende Kontakte herstellen. Hierbei werden beispielsweise die Leiteradern von Multifilamentleitern ohne Zwischenschaltung von normalleitenden Materialien direkt miteinander verbunden.

Eine entsprechende Verbindungstechnik ist z. B. in der DE-A-1 939 224 angedeutet. Gemäß dieser Technik werden an den Endstücken zweier zu verbindender Supraleiter, die jeweils mehrere in normalleitendes Stabilisierungsmaterial eingebettete supraleitende Leiteradern enthalten, die Enden dieser Leiteradern von dem Stabilisierungsmaterial entkleidet, dann unmittelbar aneinandergefügt und schließlich miteinander widerstandsarm verbunden, beispielsweise verschweißt oder verlötet. Um die Stabilisierung im Bereich dieser so erstellten Verbindungseinrichtung nicht zu unterbrechen, ist zwischen dem Stabilisierungsmaterial der Endstücke noch eine besondere Brücke aus dem Stabilisierungsmaterial vorgesehen.

Um extrem niedrige Übergangswiderstände in der vorerwähnten Größenordnung zu erhalten, können beispielsweise die supraleitenden Leiteradern direkt durch mechanische Pressung in Kontakt gebracht werden. Ein derartiges Verfahren ist z. B. in der US-A-3 422 529 beschrieben. Gemäß diesem bekannten Verfahren werden zwei supraleitende Leiteradern miteinander verdrillt, dann in eine entsprechende Preßform gebracht und schließlich durch Kaltverformung dieser Preßform aneinandergefügt.

Da bekanntlich supraleitende Legierungen wie z. B. NbTi oder NbZr eine starke Affinität zu Sauerstoff besitzen, sind ihre Oberflächen stets von einer Oxidschicht überzogen, die zudem noch normalleitend ist. Um mit diesen supraleitenden Materialien einen niederohmigen supraleitenden Kontakt herstellen zu können, muß deshalb an der Kontaktstelle die störende Oxidschicht entfernt werden. Bei dem vorerwähnten Verfahren ist deshalb eine besondere Reinigungsbehandlung der supraleitenden Leiteradern und der Preßform mittels einer chemischen Reinigungslösung vor Zusammenfügung der einzelnen Teile der Verbindungseinrichtung und deren Kaltverformung vorgesehen. Unter der Preßeinwirkung ist so eine direkte Berührung bzw. Verschweißung an einzelnen Kontaktstellen ermöglicht. Dennoch hat sich gezeigt, daß derartige Verbindungseinrichtungen nur eine verhältnismäßig geringe Stromtragfähigkeit aufweisen und zudem noch eine deutliche Abnahme des kritischen Stromes bei angelegtem Magnetfeld gegenüber dem supraleitenden Originalleitermaterial zeigen.

Aufgabe der vorliegenden Erfindung ist es, die eingangs genannte Verbindungseinrichtung zwischen den Endstücken zweier Supraleiter dahingehend zu verbessern, daß ihr Übergangswiderstand extrem gering ist, so daß mit ihr die genannten Forderungen für Magnetwicklungen von Systemen der Kernspin-Tomographie zu erfüllen sind.

Diese Aufgabe wird erfindungsgemäß durch die im kennzeichnenden Teil des Anspruchs 1 angegebenen Merkmale gelöst.

Ultraschall-Metallschweißen ist an sich allgemein bekannt (vgl. z. B. « Der Elektriker », 1978, Heft 7/8, Seiten 190 und 191 oder « Werkstatt und Betrieb », Band 114, 1981, Heft 7, Seiten 441 bis 443 oder « DVS-Berichte », Band 70, 1981, Seiten 128 bis 135). Auch zur Verbindung von supraleitendem und normalleitendem Material bei der Herstellung von stabilisierten Supraleiten wird diese Schweißtechnik angewandt (DE-C-16 65 790). Es wurde nun erkannt, daß mit dieser Schweißtechnik vorteilhaft Verbindungen auch zwischen zwei supraleitenden Leiteradern auf verhältnismäßig einfache Weise äußerst widerstandsarm herzustellen sind. Durch den Einsatz des Ultraschall-Metallschweißens können nämlich, wie aus dem Dokument « Welding Journal », Bd. 42, No. 9, Sept. 1963, S. 411-415 bekannt ist, die Oxidbeläge auf den zu verbindenden Oberflächen gezielt aufgebrochen und beseitigt werden, so daß an den gegenseitigen Berührungspunkten eine innige und großflächige Verschweißung zu erreichen ist. Auf besondere Vorbehandlungen der zu verschweißenden Einzelteile kann deshalb verzichtet werden.

Vorteilhafte Ausgestaltungen dieser erfindungsgemäßen Verbindungseinrichtung gehen aus den abhängigen Ansprüchen 2 bis 6 hervor.

Für eine weitere erfindungsgemäße Lösung der genannten Aufgabe weist die im Kennzeichen des Anspruchs 7 angegebenen Merkmale auf.

Aus « Patent Abstracts of Japan », Bd. 4, Nr. 59 (E-9) [541], 2.5.1980, Seite 65E9 zu JP-A-55 29 135 ist es bekannt, an den Enden von Supraleitern jeweils auf einer Seite eine fensterartige Zone von supraleitenden Leiteradern durch Entfernen von Stabilisierungsmaterial freizulegen und diese Zonen miteinander zu verlöten.

Mit der erfindungsgemäßen Ausbildung der Verbindungseinrichtung nach Anspruch 7 sind ebenfalls die vorstehend erläuterten Vorteile verbunden.

Diese Verbindungseinrichtung nach Anspruch 7 läßt sich vorteilhaft mit den im Kennzeichen des Anspruchs 8 angegebenen Verfahrensschritten herstellen.

Zur weiteren Erläuterung der Erfindung und deren besonderen Ausgestaltungen gemäß den Unteransprüchen wird auf die Zeichnung Bezug genommen, deren Figur 1 und 2 ein Ausführungsbeispiel einer Verbindungseinrichtung zeigen. Aus den Figuren 3 und 4 geht ein supraleitendes Endstück für eine weitere Verbindungseinrichtung nach der Erfindung hervor, die mit einer in Figur 5 angedeuteten Maschine erstellt werden kann.

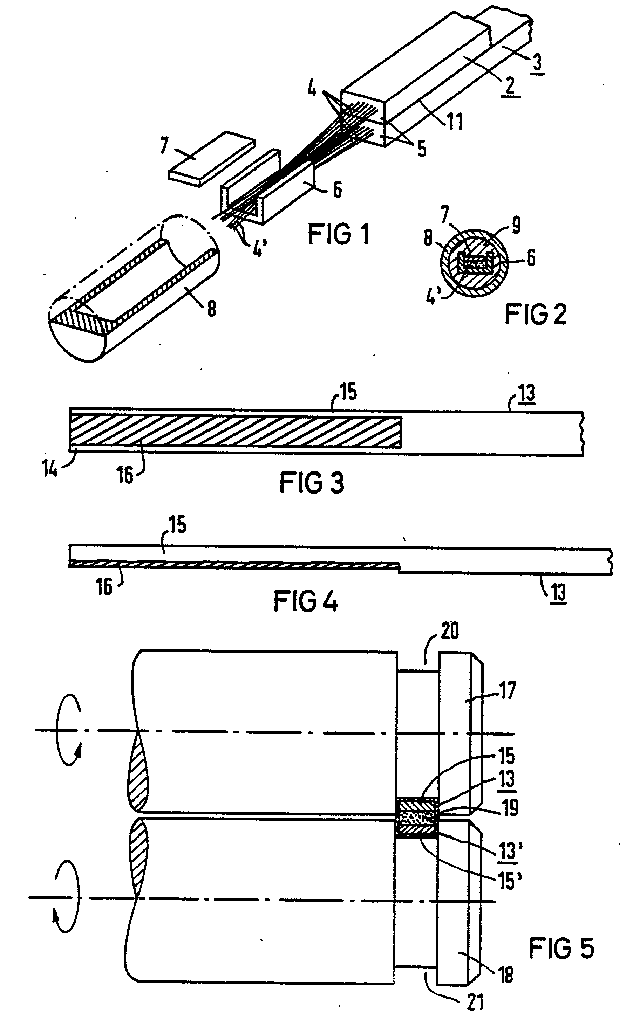

In Figur 1 sind als Schrägansicht die wesentlichen Einzelteile einer Verbindungseinrichtung nach der Erfindung schematisch veranschaulicht. Diese Verbindungseinrichtung soll zwischen den Endstücken 2 und 3 zweier Multifilament-Supraleiter einer supraleitenden Magnetwicklung ausgebildet sein, wie sie insbesondere für ein System zur Kernspin-Tomographie vorzusehen ist. Die Supraleiter enthalten jeweils eine Vielzahl von supraleitenden Leiteradern 4, die in ein Matrixmaterial 5 aus normalleitendem Stabilisierungsmaterial wie z. B. aus Kupfer oder Aluminium eingebettet sind. Im Bereich der herzustellenden Verbindung ist das Matrixmaterial 5 von den supraleitenden Leiteradern 4 abgeätzt und sind die so freigelegten Enden 4' der Leiteradern zu einem Bündel ineinandergeschoben. In diesem Bündel werden die Leiteraderenden 4' vorteilhaft möglichst gut durchmischt angeordnet, so daß sich nach Möglichkeit stets abwechselnd Leiteradern des einen Supraleiterendstückes 2 und des anderen Endstückes 3 treffen. Die Leiteraderenden 4' werden in ein im Querschnitt U-förmiges Metallprofilstück 6 eingelegt, - das als Schweißform dient, und mittels eines passenden Metallplättchens 7 als Deckel abgedeckt. U-Stück 6 und Deckel 7 können dabei aus gut elektrisch- und wärmeleitendem Material wie z. B. Kupfer bestehen. Auch härtere Materialien wie z. B. CuSn, CuBe, NbTi sind besonders geeignet, da diese Materialien die Ultraschallenergie besser in die Filamentzone der Anordnung einkoppeln können. Daneben sind auch Werkstoffpaarungen wie z. B. Cu-U-Profile mit eingelegtem NbTi-Boden und Deckel verwendbar.

Erfindungsgemäß werden die in die Schweißform 6 eingelegten und mit dem Deckel 7 abgedeckten supraleitenden Leiteraderenden 4' mittels Ultraschall-Metallschweißens verbunden. Die Einkopplung der Schallenergie erfolgt z. B. über eine entsprechend profilierte Sonotrode, die longitudinale Schwingungen ausführt. Die Sonotrode wird dabei auf den Deckel 7 mit vorbestimmter Preßkraft aufgesetzt. Parameter beim Ultraschall-Metallschweißen sind neben dem Anpreßdruck die Schweißzeit und die Amplitude. Typische Schweißzeiten liegen von etwa 0,7 bis 3 sec. bei Amplituden von etwa 20 µm, während die Anpreßkraft zwischen 70 bis 120 N variierbar ist. Als Ultraschallfrequenz kann man z. B. etwa 20 kHz wählen. Es ist jedoch auch möglich, neben Frequenzen im Ultraschallbereich auch mit Frequenzen im Schallbereich zu arbeiten.

Sind Schweißformen 6 und Deckel 7 aus Kupfer gefertigt, so läßt sich dieses Material gut durch Lötung an zusätzliches Stabilisierungsmaterial ankoppeln, das anschließend nach der Ultraschall-Metallschweißung die gesamte Verbindung aufnimmt. Hierzu kann beispielsweise ein Kupferrohr oder eine -hülse 8 vorgesehen werden. Diese Hülse ist, wie in der Figur durch gestrichelte Linien angedeutet ist, in Umfangsrichtung geschlossen. Sie wird über die Schweißverbindung geschoben und dort mit einem normalleitenden Lot, beispielsweise PbSn oder AgSn-Lot, oder insbesondere mit einem supraleitenden Lot wie z. B. PbBi verlötet. Diese Maßnahme kann zu einer Erhöhung der Stromtragfähigkeit um einen Faktor von etwa 1,5 führen.

Figur 2 zeigt einen Querschnitt der entsprechend hergestellten Verbindung im Bereich der Schweißform 6. Mit Figur 1 übereinstimmende Teile sind dabei mit den gleichen Bezugszeichen versehen. Insbesondere ist in dieser Figur das beispielsweise supraleitende Weichlot 9 ersichtlich, das die in der Schweißform 6 befindlichen, miteinander und zumindest teilweise auch mit der Schweißform verschweißten supraleitenden Leiteraderenden 4' umschließt und sich innerhalb der Stabilisierungshülse 8 befindet.

Wie in Figur 1 ferner angedeutet ist, sollen die beiden Endstücke 2 und 3 der zu verbindenden Supraleiter mit ihren Flachseiten aneinandergelegt und dort großflächig verlötet sein. Hierzu dient ein normalleitendes Weichlot 11, das so eine elektrisch gut leitende Brücke zwischen dem stabilisierenden Material 5 der beiden Supraleiter im Bereich der Verbindungseinrichtung darstellt.

Zur weiteren Stabilisierung der Schweißverbindung kann auch vor dem Schweißvorgang noch zusätzliches Material in die U-förmige Schweißform 6 mit eingebaut werden. z. B. können Kupfer-Drähte oder Späne in den Innenbereich der Filamentzone geschoben werden. Dadurch erhält man nach der Schweißung eine innenstabilisierte Leiteranordnung. In ähnlicher Weise führt das Einbringen von zusätzlichen supraleitenden Filamenten oder Spänen geeigneter Abmessungen zu einer erhöhten Packungsdichte und einer vergrößerten Anzahl von Berührungsstellen zwischen den supraleitenden Leiteraderenden. Hiermit können insbesondere Hohlräume innerhalb des Verbundes eliminiert werden.

Mit einer Verbindungseinrichtung gemäß der Erfindung können auch Leiter mit sehr dünnen Supraleiterfilamenten und einlagiger Filamentzone verbunden werden. Ein Ausführungsbeispiel des Endstückes eines Leiters des letztgenannten Typs ist in Figur 3 in Aufsicht und in Figur 4 als Seitenansicht schematisch veranschaulicht. Hierbei wird bei jedem Leiterendstück 13 einseitig ein Fenster 14 aus der umhüllenden Stabilisierungsmatrix 15 herausgeätzt, so daß dort auf einer Seite eine entsprechende Zone 16 der Leiteradern freigelegt ist. Für die axiale Ausdehnung des Fensters 14 wird vorteilhaft ein Vielfaches der Twistlänge der einzelnen Leiteradern vorgesehen, wodurch sämtliche freiliegenden Leiteradern gleichmäßig am Stromübertritt beteiligt werden. Die Verschweißung kann vorteilhaft in einer Ultraschall-Rollnahtschweißmaschine erfolgen, wie sie beispielsweise in Figur 5 als Seitenansicht auf die Stirnseite der verschweißten Endstücke schematisch angedeutet ist. Mit Figur 3 und 4 übereinstimmende Teile sind dabei mit den gleichen Bezugszeichen versehen.

Die in Figur 5 angedeutete Maschine enthält eine oben drehbare Führungsrolle 17, die mit einer Ultraschall-Schweißvorrichtung gekoppelt ist, sowie eine entsprechende Gegenrolle 18. Zwischen den beiden Rollen werden die miteinander zu verschweißenden Bereiche der Endstücke 13 und 13' der Supraleiter hindurchgeführt, wobei eine vorbestimmte Preßkraft auf ihre von der Stabilisierungsmatrix 15 bzw. 15' freigelegten Zonen aus den supraleitenden Leiteradern eingestellt wird. Diese miteinander verschweißten Zonen sind in der Figur mit 19 bezeichnet. Zur Führung der Endstücke ist in den Rollen in Umfangsrichtung jeweils eine den Abmessungen des jeweiligen Endstückes angepaßte Führungsnut 20 bzw. 21 vorgesehen. Die so erstellte Schweißverbindung läßt sich dann noch beispielsweise entsprechend dem anhand der Figuren 1 und 2 erläuterten Ausführungsbeispiel von außen mit zusätzlichem Stabilisierungsmaterial versehen.

**Patentansprüche**

1. Verbindungseinrichtung zwischen den Endstücken zweier auf kryogene Betriebstemperatur abzukühlender Supraleiter, die jeweils in eine Matrix aus normalleitendem Stabilisierungsmaterial eingebettete supraleitende Leiteradern enthalten, wobei die Enden der zu verbindenden supraleitenden Leiteradern von dem Stabilisierungsmaterial entkleidet, unmittelbar aneinandergefügt und miteinander verschweißt sind, und wobei zwischen dem Stabilisierungsmaterial der Supraleiter eine elektrisch gut leitende Brücke aus normalleitendem Material ausgebildet ist, dadurch gekennzeichnet, daß die aus dem Matrixmaterial herausgeätzten Enden (4') der supraleitenden Leiteradern (4) beider zu verbindender Supraleiter ineinandergeschoben und durchmischt in einer Schweißform (6, 7) angeordnet und mittels einer Ultraschall-Metallschweißung miteinander und zumindest teilweise auch mit der Schweißform verbunden sind.

2. Verbindungseinrichtung nach Anspruch 1, dadurch gekennzeichnet, daß die Schweißform aus einem U-förmigen Metallprofilkörper (6) und einem entsprechenden Deckel (7) besteht.

3. Verbindungseinrichtung nach Anspruch 1 oder 2, dadurch gekennzeichnet, daß die Schweißform (6, 7) zumindest teilweise aus normalleitendem Material besteht.

4. Verbindungseinrichtung nach Anspruch 3, dadurch gekennzeichnet, daß die Schweißform (6, 7) zumindest teilweise aus elektrisch gut leitendem Material, insbesondere dem Stabilisierungsmaterial der Supraleiter besteht.

5. Verbindungseinrichtung nach einem der Ansprüche 1 bis 4, dadurch gekennzeichnet, daß die Schweißform (6, 7) zumindest teilweise aus supraleitendem Material besteht.

6. Verbindungseinrichtung nach einem der Ansprüche 1 bis 5, dadurch gekennzeichnet, daß die supraleitenden Leiteraderenden (4') einschließlich ihrer Schweißform (6, 7) von supraleitendem Lotmaterial (9) umgeben sind.

7. Verbindungseinrichtung zwischen den Endstücken zweier auf kryogene Betriebstemperatur abzukühlender Supraleiter, die jeweils in eine Matrix aus normalleitendem Stabilisierungsmaterial eingebettete supraleitende Leiteradern enthalten, wobei die zu verbindenden supraleitenden Leiteradern teilweise von dem Stabilisierungsmaterial entkleidet, unmittelbar aneinandergefügt und miteinander verschweißt sind, und wobei zwischen dem Stabilisierungsmaterial der Supraleiter eine elektrisch gut leitende Brücke aus normalleitendem Material ausgebildet ist, dadurch gekennzeichnet, daß die Supraleiter (13, 13') eine Lage aus mehreren mit einander vertwisteten supraleitenden Leiteradern aufweisen, daß an den Enden der Supraleiter (13, 13') jeweils auf einer Seite eine fensterartige Zone (16) von supraleitenden Leiteradern durch Herausätzen des Stabilisierungsmaterials freigelegt ist, wobei die Ausdehnung dieser fensterartigen Zonen (16) in Leiterlängsrichtung ein vielfaches der Twistlänge der einzelnen supraleitenden Leiteradern beträgt, und daß die supraleitenden Leiteradern innerhalb des fensterartigen Zonen (16) mittels einer Ultraschall-Metallschweißung miteinander verbunden sind.

8. Verfahren zur Herstellung einer Verbindungseinrichtung nach Anspruch 7, dadurch gekennzeichnet, daß die zu verschweißenden Endstücke der Supraleiter (13, 13') zwischen den beiden Rollen (17, 18) einer Rollnahtschweißmaschine hindurchgeführt werden, wobei über die Rollen (17, 18) die jeweils mit einer an die Abmessungen des jeweiligen Endstücks des Supraleiters angepaßten Führungsnut (20 bzw. 21) versehenen sind, eine vorbestimmte Preßkraft auf die von dem Stabilisierungsmaterial freigelegten, zu verschweißenden fensterartigen Zonen (16) der Supraleiter (13, 13') ausgeübt wird und wobei die Ultraschall-Metallschweißung über eine der Rollen (17) erfolgt.

## Claims

1. A connecting device between the end pieces of two superconductors which are to be cooled down to cryogenic operating temperature and which in each case contain superconducting conductor filaments embedded in a matrix of normally conducting stabilising material, where the ends of the superconducting conductor filaments which are to be connected, are stripped of the stabilising material, brought into direct contact with one another, and welded to one another, and where an electrically highly conductive bridge of normally conducting material is provided between the stabilising material of the superconductors, characterised in that the ends (4') of the superconducting conductor filaments (4) of the two superconductors to be connected and which have been etched out of the matrix material, are inserted into one another, placed intermingled in a welding mould (6, 7), and by means of ultrasonic metal welding are connected to one another and at least in part also to the welding mould.

2. A connecting device as claimed in Claim 1, characterised in that the welding mould consists of a U-shaped metal profiled part (6) and a corresponding cover (7).

3. A connecting device as claimed in Claim 1 or 2, characterised in that the welding mould (6, 7) consists at least in part of normally conducting material.

4. A connecting device as claimed in Claim 3, characterised in that the welding mould (6, 7) consists at least in part of electrically highly conductive material, in particular, the stabilising material of the superconductors.

5. A connecting device as claimed in one of Claims 1 to 4, characterised in that the welding mould (6, 7) consists at least in part of superconducting material.

6. A connecting device as claimed in one of Claims 1 to 5, characterised in that the superconducting conductor filament ends (4') and their welding mould (6, 7) are surrounded by superconducting soldering material (9).

7. A connecting device between the end pieces of two superconductors which are to be cooled down to cryogenic operating temperature and which in each case contain superconducting conductor filaments, embedded in a matrix of normally conducting stabilising material, where the superconducting conductor filaments which are to be connected are partially stripped of the stabilising material, brought into direct contact with one another, and welded to one another, and where an electrically highly conductive bridge of normally conducting material is provided between the stabilising material of the superconductors, characterised in that the superconductors (13, 13') have a layer made of a plurality of superconducting conductor filaments twisted together; that at the ends of the superconductors (13, 13') on one side in each case, a window-like zone (16) of the superconducting conductor filaments is exposed by etching away the stabilising material, the extension of these window-like zones (16) in the longitudinal direction of the conductors being a multiple of the twist length of the individual superconducting conductor filaments; and that the superconducting conductor filaments are connected to one another within the window-like zones (16) by ultrasonic metal welding.

8. A process for the production of a connecting device as claimed in Claim 7, characterised in that the end pieces of the superconductors (13, 13') which are to be welded, are brought between the two rollers (17, 18) of a roller seam welder, where, through the rollers (17, 18), each of which is provided with a guide groove (20, 21) adapted to the dimensions of the respective end piece of the superconductor, a predetermined pressure is exerted on the window-like zones (16) of the superconductors (13, 13') which have been freed from the stabilising material and which are to be welded, and where the ultrasonic metal welding is carried out by way of one of the rollers (17).

## Revendications

1. Dispositif de connexion entre les bouts de deux supraconducteurs à refroidir à une température de fonctionnement cryogène, qui comportent chacun des brins supraconducteurs noyés dans une matrice de matériau de stabilisation à conduction normale, dispositif pour la mise en

œuvre duquel les extrémités des brins supraconducteurs à connecter sont dénudées par enlèvement du matériau de stabilisation, jointes directement et soudées ensemble, et dans lequel un pont bon conducteur électrique en matériau à conduction normale est formé entre les matériaux de stabilisation des supraconducteurs, caractérisé en ce que les extrémités (4') des brins supraconducteurs (4) des deux supraconducteurs à connecter, extrémités qui sont dégagées du matériau matriciel par gravure, sont insérées les unes dans les autres et sont disposées en étant mélangées dans un moule à souder (6, 7) et reliées entre elles et au moins en partie aussi à la forme à souder par une soudure de métaux par ultrasons.

2. Dispositif selon la revendication 1, caractérisé en ce que le moule à souder est constitué d'un profilé métallique en U (6) et d'un couvercle (7) complémentaire.

3. Dispositif selon la revendication 1 ou 2, caractérisé en ce que le moule à souder (6, 7) est en partie au moins en matériau à conduction normale.

4. Dispositif selon la revendication 3, caractérisé en ce que le moule à souder (6, 7) est constitué au moins en partie d'un matériau bon conducteur électrique, en particulier du matériau de stabilisation des supraconducteurs.

5. Dispositif selon une des revendications 1 à 4, caractérisé en ce que le moule à souder (6, 7) est en partie au moins en matériau supraconducteur.

6. Dispositif selon une des revendications 1 à 5, caractérisé en ce que les extrémités (4') des brins supraconducteurs, y compris leur moule à souder (6, 7), sont entourés de brasure (9) supraconductrice.

7. Dispositif de connexion entre les bouts de deux supraconducteurs à refroidir à une température de fonctionnement cryogène, qui comportent chacun des brins supraconducteurs noyés dans une matrice de matériau de stabilisation à conduction normale, dispositif pour la mise en œuvre duquel les brins supraconducteurs à connecter sont partiellement dénudés par l'enlèvement du matériau de stabilisation, joints directement et soudés ensemble, et dans lequel un pont bon conducteur électrique en matériau à conduction normale est formé entre les matériaux de stabilisation des supraconducteurs, caractérisé en ce que les supraconducteurs (13, 13') présentent une couche de plusieurs brins supraconducteurs torsadés ensemble, qu'une zone (16) semblable à une fenêtre de brins supraconducteurs est dégagée unilatéralement, par enlèvement par gravure du matériau de stabilisation, sur chacune des extrémités des supraconducteurs (13, 13'), l'étendue de ces zones (16) semblables à des fenêtres dans le sens de la longueur des conducteurs représentant un multiple du pas de torsion des différents brins supraconducteurs, et que les brins supraconducteurs sont reliés entre eux, dans les zones (16) semblables à des fenêtres, par un soudage de métaux par ultrasons.

8. Procédé pour réaliser un dispositif de connexion selon la revendication 7, caractérisé en ce que l'on fait passer les bouts à souder ensemble des supraconducteurs (13, 13') entre les deux galets (17, 18) d'une machine à souder à la molette, les galets (17, 18) étant pourvus chacun d'une gorge de guidage (20 ou 21) adaptée aux dimensions du bout de supraconducteur concerné, avec application d'une force de pression déterminée aux zones (16) semblables à des fenêtres des supraconducteurs (13, 13'), zones qui sont débarrassées du matériau de stabilisation et sont à souder ensemble, et avec exécution d'une opération de soudage de métaux par ultrasons par l'un des galets (17).

FIG 1

FIG 2

FIG 3

FIG 4

FIG 5